(19) Europäisches Patentamt
European Patent Office
Office européen des brevets

(11) **EP 2 811 520 A1**

(12) **EUROPEAN PATENT APPLICATION**

(43) Date of publication:
**10.12.2014 Bulletin 2014/50**

(51) Int Cl.:
*H01L 27/06* (2006.01)          *G05F 3/20* (2006.01)
*H01L 27/088* (2006.01)

(21) Application number: **13170653.3**

(22) Date of filing: **05.06.2013**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **NXP B.V.**
**5656 AG Eindhoven (NL)**

(72) Inventor: **Rutter, Philip**
**Redhill, Surrey RH1 1SH (GB)**

(74) Representative: **Crawford, Andrew**
**NXP B.V.**
**Intellectual Property & Licensing**
**Red Central**
**60 High Street**
**Redhill, Surrey RH1 1SH (GB)**

(54) **Gallium nitride device**

(57)     A semiconductor device (10) formed on a substrate, the device comprising: a first terminal (12); a second terminal (16), and a voltage divider (18) having a common node (11), and first and second end nodes connected to respective said first (12) and second (16) terminals; wherein the common node (11) of the voltage divider (18) is connected to said substrate and is arranged such that in use the voltage divider (18) biases the substrate to a voltage intermediate that applied to said first and second terminals.

FIG. 1

Printed by Jouve, 75001 PARIS (FR)

EP 2 811 520 A1

**Description**

FIELD

The present invention relates to gallium nitride based semiconductor devices. In particular the invention relates to such devices fabricated on a silicon substrate.

BACKGROUND

Gallium nitride (GaN) based semiconductor devices, such as MOSFETs, HEMTs and diodes, are ideal candidates for high-power and high-temperature applications due to large band-gap of GaN semiconductor materials. Typically, when compared with Silicon (Si), GaN devices outperform due to the wide direct energy band gap of 3.4eV, high critical field of 3MV/cm, comparable carrier mobility, and good thermal conductivity. The large band-gap means that devices formed from GaN can reliably operate at higher breakdown voltages and temperatures when compared with Si based devices.

GaN based devices are typically formed by depositing a thin layer of GaN based material on top of a standard silicon wafer substrates. However, the cost of forming such devices is high, when compared with standard Si processes, due to the complex nature of the epitaxial growth. This complexity arises because in addition to the material required for the electrical performance (e.g. to meet the device breakdown voltage requirements), typically it may also be necessary to grow a so-called super lattice of alternating buffer layers (for example AlGaN/GaN) that aims to accommodate the lattice mismatch between the silicon substrate and the overlying GaN device layers so as reduce crystal defects in the device.

As a result of the buffer layer structure, and as the breakdown voltage requirement of devices increases, the wafer cost also increases. This increase is due to the thicker GaN device layer needed and the thicker buffer layers needed to balance the increased strain in the device. As the thickness of the buffer layers is increased, the maximum breakdown voltage of the device will also increase. High voltage devices, for example operating in the 600 volt region, will require a certain buffer layer thickness.

In GaN based devices there may be defects created due to the lattice mismatch between GaN buffer/device layers and Si substrate. These defects may act as generation and/or recombination centers or traps that can impact device performance (for example causing current collapse). By reducing the voltage swing, that is the total charge vertically across the device (for example substrate to drain or anode to cathode) as it is switched from an on state to an off state at the Si/GaN interface (including the buffer layers), the impact of these traps will be reduced. For example with a device substrate held at source voltage, as device goes from on state to off state the voltage between substrate and drain will be equal to that of source to drain. Therefore the construction the GaN on Si wafer will need to withstand this voltage usually by having thicker GaN and buffer layers therefore increasing costs and creating more defects or traps. Therefore as the breakdown voltage of a device rises, the resultant increase in buffer layer thickness adds substantially to device manufacturing costs and increased traps and defects.

For example, increasing the breakdown voltage rating from 300V to 600V rating results in an increase in layer growth time of approximately 25%. Factoring in equipment depreciations and consumable costs this results in an increase 20% of the total final device cost. There is therefore a need to limit the buffer layer thickness whilst maintaining vertical breakdown voltage rating of GaN based semiconductor devices.

SUMMARY

There is provided a semiconductor device formed on a substrate, the device comprising: a first terminal; a second terminal, and a voltage divider having a common node, and first and second end nodes connected to respective said first and second terminals; wherein the common node of the voltage divider is connected to said substrate and is arranged such that in use the voltage divider biases the substrate to a voltage intermediate that applied to said first and second terminals. By biasing the substrate in this way a lower voltage rated substrate may be used without decreasing the breakdown voltage rating of the device.

According to embodiments the voltage divider is arranged to bias the substrate to a voltage less than the voltage applied to the first and second terminals. The device may be a transistor or a diode. The device may be a gallium nitride device formed on a silicon substrate.

DESCRIPTION OF THE DRAWINGS

The invention is described further hereinafter by way of example only with reference to the accompanying drawings in which:

Figure 1 is a circuit diagram of a MOSFET semiconductor device including a voltage divider;

Figure 2 is a schematic layout of a MOSFET semiconductor device illustrating the additional impedances on the device substrate;

Figure 3 is a further schematic layout of a MOSFET semiconductor device illustrating the additional impedances on the device substrate;

Figure 4 is a yet further schematic layout of a MOSFET semiconductor device illustrating the additional impedances on the device substrate; and

Figure 5 is a schematic layout of a MOSFET semiconductor device illustrating the additional impedances on the device leadframe.

In the figures and the following description like reference numerals refer to like features.

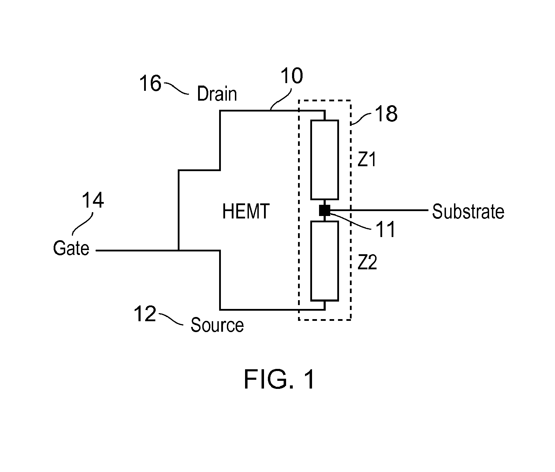

Figure 1 shows a circuit diagram of a semiconductor device. In this example the semiconductor device is a MOSFET device 10. The MOSFET device 10 is formed on a GaN buffer layer grown on a silicon substrate (not illustrated in Figure 1). The GaN buffer layer may be a lattice type layer or a single layer. That is to say, it will be understood that the generic term "buffer layer", may include a plurality of individual layers arranged as a lattice or super-lattice" The MOSFET device 10 comprises source 12, gate 14 and drain 16 terminals. A voltage divider 18 is connected in parallel across the source 12 and drain terminals. The voltage divider 18 may comprise a first impedance Z1 and a second impedance Z2 where the connections common to both the first impedance Z1 and second impedance Z2 form a common node 11. The common node 11 of the voltage divider 18 is electrically connected to the silicon substrate as discussed in more detail below.

When the MOSFET device 10 is in use, a potential difference (not illustrated) is applied across the source 12 and drain 16 terminals. Through use of the voltage divider 18, the common node 11 may be set at a potential which is intermediate the potential of the source 12 and the potential of the drain 16. By connecting the common node 11 to the substrate, the substrate may be biased at for example the potential difference across the common node 11 and the source terminal 16, where the source is at a lower potential than the drain. Alternatively the substrate may be biased at the potential across the common node 11 and the drain terminal, where the drain terminal is at a lower potential to the source. If the first and second impedances Z1, Z2 are equal in value, the potential at the common node 11 will be half that of the potential across the source 12 and drain 16 terminals of the device.

By way of example, for high voltage GaN MOSFET devices fabricated on Si substrates the maximum breakdown voltage (that is the maximum voltage that can be applied across the source and drain) may be 600V.

Applying the following voltage divider equation:

$$Vout = \frac{Z2}{Z1+Z2} . Vin \qquad \text{Eqn.1}$$

Where:

Vout is the potential difference on the common node 11.

Z1 and Z2 are the first and second impedances respectively

Vin is the potential difference across the source and drain terminals.

When Z1 = Z2 Eqn.1 becomes:

$$Vout = \frac{1}{2} . Vin \qquad \text{Eqn.2}$$

Therefore if the two impedances Z1 and Z2 are equal, then the voltage at which the substrate would be midway between the voltage across the source and drain terminals. Taking the example of Vin as 600V given above, Vout and therefore the bias potential of the substrate will be 300V. The maximum source to substrate (or common node) voltage and drain to substrate (or common node) voltage would be half the maximum voltage rating of the device.

Therefore following this example a 600V device breakdown voltage device could be constructed using 300V rated substrates. As previously mentioned the voltage rating of a substrate is dependent on the thickness of the GaN buffer layer. For example, GaN devices may be formed as lateral type devices such that the device drain to source voltage rating is dependent on the length of the lateral material. Conventionally, the substrate may be connected to a fixed potential (typically the source potential), therefore this gives rise to source-substrate and drain-substrate breakdown voltages. The source- and drain-substrate voltages that are a function of the thickness of the GaN buffer and layers. In the example here, the substrate voltage is half the voltage between source and drain so the voltage change seen vertically is now halved. Therefore the change in electric field vertically is reduced It is known that the electric field in a device can affect the behavior of traps.

By allowing biasing the substrate it is possible to thin the substrate as the vertical breakdown voltage requirement is reduced, and as thinner layers are grown a lower lower density of defect states will arise in the grown device. Since the device and buffer layers are thinner due to the lower voltage requirement, the defect density will be much reduced. In addition by a reduced voltage swing would ensure that less material is subjected to changes in electric field, which affects the behavior of traps.

For situations where the first impedance Z1 does not equal Z2 Eqn 1 above will apply, and the skilled person will recognise that the output voltage will be less than the input voltage. In view of this the skilled person will also recognise that it is possible to bias the substrate according to individual needs through appropriate selection of the impedances Z1 and Z2. The skilled person will therefore understand that the voltage divider may be configured to bias the substrate to between approximately 30% and 60% of the maximum voltage applied across the source and drain terminals of the device.

The voltage divider 18 may comprise at least two impedances Z1 and Z2. Alternatively and where the impedance is implemented as a resistance it may be possible to implement the voltage divider as a single resistor connected between drain and source, as discussed above together with a connection to the substrate at a tap-point suitably located along the length of that resistor.

The impedances Z1, Z2 may either be resistors, capacitors or a combination of resistors and capacitors. The impedances Z1, Z2 may also be formed of transistors. The impedances may be fabricated on the GaN buffer layer on Si substrate. The impedances may be connected to the source 12, drain 16 and substrate as discussed in more detail below. Alternatively the impedances may be fabricated directly on the Si substrate with appropriate buffer layers.

If the impedances Z1, Z2 are resistors and incorporated onto the substrate of the MOSFET device 10 they may be implemented as a pure resistor, for example by dimensioning of a conductive material, or by using a transistor configured to be permanently on. Alternatively, the impedances Z1, Z2 can be additional external components included in the assembly (for example on the lead frame) of the final product, as discussed in more detail below.

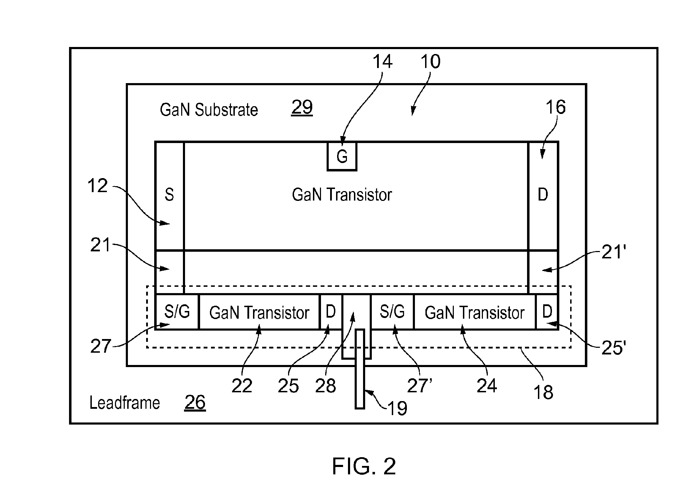

Figure 2 shows an implementation where the first Z1 and second Z2 impedances are respective first and second transistors 22, 24 arranged so as to form the voltage divider 18 (as shown in the circuit diagram of Figure 1). The first and second transistors 22, 24 are formed on the buffer layer of same Si substrate 29 of the MOSFET device 10. The MOSFET device 10 may be mounted on a suitable leadframe 26. The first and second transistors 22, 24 may be high resistance devices. The first and second transistors 22, 24 may be "normally on" (also known as depletion mode) transistors fabricated in series on the substrate 29 and connected in parallel to the MOSFET device 10. The gate and source terminals 27, 27' of each of first and second transistors 22, 24 are connected together thus ensuring that they are always on. As a result, where the resistances of the first and second transistors 22, 24 are equal, during operation the voltage at a midpoint 28 of the transistors 22, 24 will be half of the drain source voltage on the MOSFET device 10.

The source and gate terminals 27 of the first transistor 22 may be connected to the source terminal 12 of the MOSFET device by any suitable means such as for example a metal layer interconnect 21. The drain terminal 25 of the first transistor 22 is connected to the source and gate terminal 27' of the second transistor 24 by any suitable means, such as for example a metal layer interconnect which can also form the midpoint 28. This interconnection forms the midpoint 11 of the voltage divider 18 illustrated in Figure 1. The drain terminal 25' of the second transistor 24 is connected to the drain terminal 16 of the MOSFET device 10 by a metal layer interconnect 21'.

The midpoint of the voltage divider 28 may be connected to the substrate 29 using a lead frame of the device or appropriate via connection. Where the connection is made using the leadframe of the device, which in most cases will be metallic, the substrate may be mounted onto the leadframe so that they are also electrically connected. A wirebond connection 19 from the midpoint 28 to the leadframe achieves electrical connection of the midpoint to the leadframe. The drain 16 or source 12 terminals may be connected to the substrate by similar means. The gate terminal 14 of the device can be any appropriate connection.

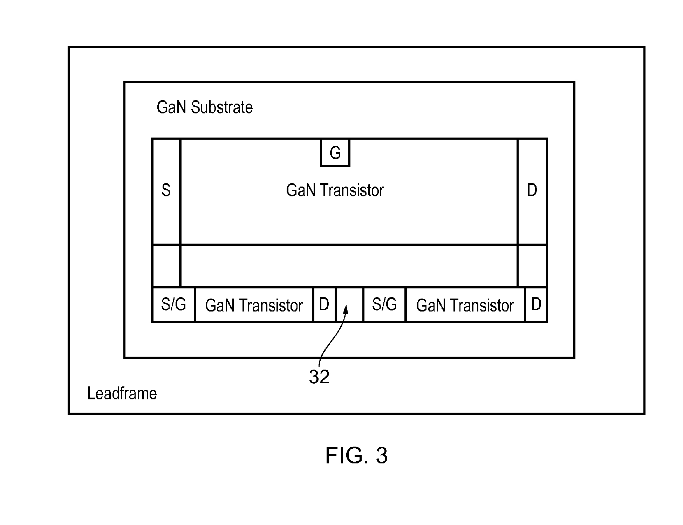

Alternatively (as illustrated in Figure 3) the connection of the substrate 29 may be made by one or more suitable through hole vias 32 etched through the substrate to the leadframe and filled with a suitable conductive material to make the electrical connection from the midpoint 28 to the substrate 29. As an example, the suitable conductive material may be aluminum but the skilled person will recognise that any suitable conductive material may be used.

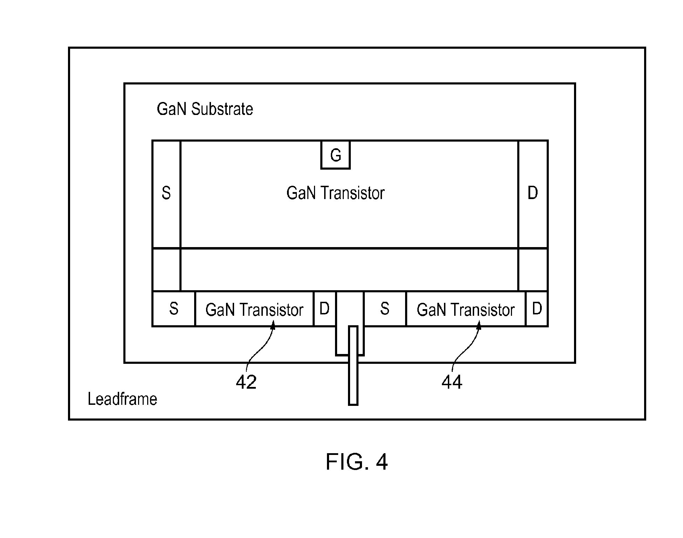

As illustrated in Figure 4, the first and second impedances Z1, Z2 may be first and second resistors 42, 44. The resistors 42, 44 are connected to the MOSFET 10 in the voltage divider 18 arrangement illustrated in Figure 1. As with the implementation of Figures 2 and 3, the first and second resistors 42, 44 may be formed on the substrate 29.

Where transistors are used to form the impedances Z1, Z2 the same material as the MOSFET device 10 may be used.

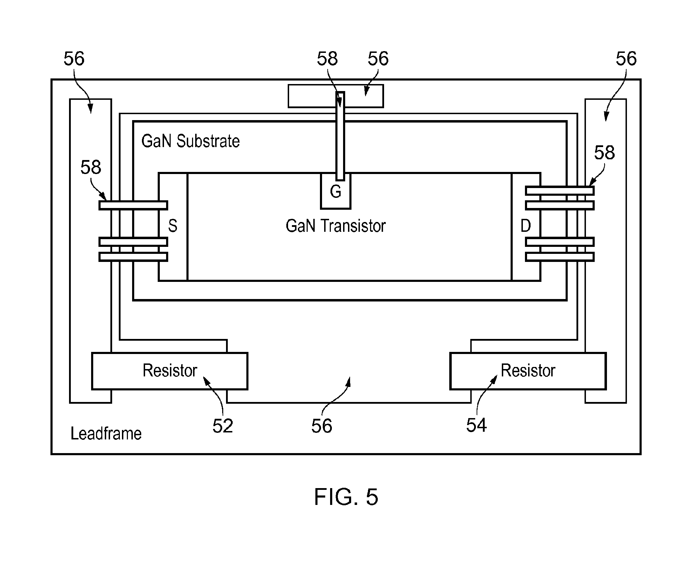

The skilled person will recognise that it is not necessary to form the transistors 22, 24 or resistances 42, 44 on the substrate and that they may be formed externally to the substrate and connected to the MOSFET device 10. As illustrated in Figure 5 the voltage divider 18 can be implemented using external components. Here the first and second impedances Z1, Z2 can be first and second resistors 52, 54. The MOSFET device 10 is placed on the leadframe that has patterned electrical connections 56 that allow for external components to be connected in the appropriate manner to form the voltage divider 18 arrangement described above. Bondwires 58 may be used to make the appropriate connections to the patterned connections 56 to the terminals of the MOSFET device 10. The external components create a voltage divider that sets the voltage on the GaN substrate according to the drain source voltage of the GaN device. The skilled person will appreciate that the electrical connections can be made in any appropriate manner depending on the application.

The skilled person will recognise that the arrangements herein may also be applicable to lateral High Electron Mobility Transistor (HEMT) devices. The arrangements discussed herein may also be applicable to two terminal devices such as diodes. In this case the anode and cathode connections of the diode will be equivalent to the source and drain terminals of the MOSFET arrangement discussed herein. Based on the forgoing the skilled person will also recognise that the arrangements herein may be applied to any appropriate device material such as silicon on insulator (SOI) technology and substrate, not merely the example of GaN/Si types described herein.

The arrangements described herein can be used in any application needing high voltage power devices such as transistors or diodes which typically have breakdown voltages of several hundreds of volts. For example applications can include automotive or voltage conversion applications and in particular power factor correction (PFC) circuits. Power Factor Correction (PFC) circuits are used to isolate AC-DC mains converter supplies used for mobile computing and telecommunications devices. In such power supplies the AC input effectively sees a large inductive load, which can causes the power factor of the power supply to be less than one. PFC circuits allow the AC input to see a near unity power factor. Near unity power factors are now required by state and national laws depending on the output power of the power supply. A common PCF circuit is the active boost PFC, which ensures that the current drawn from the supply is sinusoidal (i.e. harmonic free) and in phase with the current.

Particular and preferred aspects of the invention are set out in the accompanying independent claims. Combinations of features from the dependent and/or independent claims may be combined as appropriate and not merely as set out in the claims.

The scope of the present disclosure includes any novel feature or combination of features disclosed therein either explicitly or implicitly or any generalisation thereof irrespective of whether or not it relates to the claimed invention or mitigate against any or all of the problems addressed by the present invention. The applicant hereby gives notice that new claims may be formulated to such features during prosecution of this application or of any such further application derived there from. In particular, with reference to the appended claims, features from dependent claims may be combined with those of the independent claims and features from respective independent claims may be combined in any appropriate manner and not merely in specific combinations enumerated in the claims.

Features which are described in the context of separate embodiments may also be provided in combination in a single embodiment. Conversely, various features which are, for brevity, described in the context of a single embodiment, may also be provided separately or in any suitable sub combination.

For the sake of completeness it is also stated that the term "comprising" does not exclude other elements or steps, the term "a" or "an" does not exclude a plurality, a single processor or other unit may fulfill the functions of several means recited in the claims and reference signs in the claims shall not be construed as limiting the scope of the claims.

**Claims**

1. A semiconductor device formed on a substrate, the device comprising: a first terminal; a second terminal, and a voltage divider having a common node, and first and second end nodes connected to respective said first and second terminals; wherein the common node of the voltage divider is connected to said substrate and is arranged such that in use the voltage divider biases the substrate to a voltage intermediate that applied to said first and second terminals.

2. The semiconductor device of claim 1, wherein said semiconductor device comprises a transistor and further comprises a third terminal.

3. The semiconductor device of claim 2, wherein the transistor is a field effect transistor, the first terminal is a source terminal, and the second terminal is a drain terminal.

4. The semiconductor device of claim 1, wherein said semiconductor device comprises a diode wherein, the first terminal is an anode and the second terminal is a cathode.

5. The semiconductor device of any preceding claim, wherein the voltage divider is arranged to bias the substrate to a voltage less than the voltage applied across the first and second terminals.

6. The semiconductor device of any preceding claim, wherein the voltage divider is formed of impedances.

7. The semiconductor device of claim 6, wherein the impedances are capacitances.

8. The semiconductor device of claim 6, wherein the impedances are resistances.

9. The semiconductor device of claims 6 to 8, wherein the voltage divider is formed of a combination of capacitances and resistances.

10. The semiconductor device of claim 6, wherein the impedances are formed of transistors.

11. The semiconductor device of any preceding claim wherein the device is a gallium nitride device formed on a silicon substrate.

12. A power factor correction circuit comprising the semiconductor device as claimed in any of claims 1 to 11.

13. A power supply comprising the power factor correction circuit of claim 12.

FIG. 1

FIG. 2

FIG. 3

FIG. 4

FIG. 5

Europäisches
Patentamt

European
Patent Office

Office européen
des brevets

# EUROPEAN SEARCH REPORT

**Application Number**

EP 13 17 0653

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2012/217542 A1 (MORITA TATSUO [JP]) 30 August 2012 (2012-08-30) | 1-3,5,6, 8-11 | INV. H01L27/06 |
| Y | * paragraphs [0040], [0065], [0066]; figures 2,5 * | 12,13 | G05F3/20 |
| | ----- | | ADD. |
| Y | US 2007/254431 A1 (SAITO WATARU [JP] ET AL) 1 November 2007 (2007-11-01) * paragraphs [0006], [0007], [0029], [0052]; figure 3 * | 1-7,9, 11-13 | H01L27/088 |
| | ----- | | |
| Y | US 2012/313692 A1 (SUTARDJA SEHAT [US] ET AL) 13 December 2012 (2012-12-13) * paragraphs [0004], [0029], [0032]; figure 3 * | 1-7,9, 11-13 | |
| | ----- | | |
| Y | US 2005/105311 A1 (SOLDANO MARCO [US]) 19 May 2005 (2005-05-19) * paragraph [0055]; figures 2,4 * | 12,13 | |
| | ----- | | |
| A | US 2009/206363 A1 (MACHIDA OSAMU [JP] ET AL) 20 August 2009 (2009-08-20) * paragraph [0015] * | 3 | TECHNICAL FIELDS SEARCHED (IPC) |
| | ----- | | H01L |
| A | US 5 233 289 A (BEASOM JAMES D [US]) 3 August 1993 (1993-08-03) * column 1, line 7 - line 44 * | 10 | G05F |
| | ----- | | |

The present search report has been drawn up for all claims

| Place of search | Date of completion of the search | Examiner |
|---|---|---|
| Munich | 28 January 2014 | Seck, Martin |

EPO FORM 1503 03.82 (P04C01)

## ANNEX TO THE EUROPEAN SEARCH REPORT
## ON EUROPEAN PATENT APPLICATION NO.

EP 13 17 0653

This annex lists the patent family members relating to the patent documents cited in the above-mentioned European search report.
The members are as contained in the European Patent Office EDP file on
The European Patent Office is in no way liable for these particulars which are merely given for the purpose of information.

28-01-2014

| Patent document cited in search report | | Publication date | Patent family member(s) | | Publication date |
|---|---|---|---|---|---|
| US 2012217542 | A1 | 30-08-2012 | CN US WO | 102612753 A 2012217542 A1 2011064955 A1 | 25-07-2012 30-08-2012 03-06-2011 |
| US 2007254431 | A1 | 01-11-2007 | JP US | 2007294769 A 2007254431 A1 | 08-11-2007 01-11-2007 |
| US 2012313692 | A1 | 13-12-2012 | TW US WO | 201250986 A 2012313692 A1 2012170148 A1 | 16-12-2012 13-12-2012 13-12-2012 |
| US 2005105311 | A1 | 19-05-2005 | DE JP TW US WO | 112004001850 T5 2007527687 A I279971 B 2005105311 A1 2005033819 A2 | 10-08-2006 27-09-2007 21-04-2007 19-05-2005 14-04-2005 |
| US 2009206363 | A1 | 20-08-2009 | JP US | 2009200149 A 2009206363 A1 | 03-09-2009 20-08-2009 |
| US 5233289 | A | 03-08-1993 | US US | 5233289 A 5493207 A | 03-08-1993 20-02-1996 |

EPO FORM P0459

For more details about this annex : see Official Journal of the European Patent Office, No. 12/82